Europäisches Patentamt

(19) European Patent Office

Office européen des brevets

(11) Publication number: **0 106 475**

**A1**

# (12) EUROPEAN PATENT APPLICATION

(21) Application number: **83305062.8**

(22) Date of filing: **01.09.83**

(51) Int. Cl.³: **H 01 L 21/56**
**B 29 C 6/04**

(30) Priority: **04.10.82 US 432571**

(43) Date of publication of application:
**25.04.84 Bulletin 84/17**

(84) Designated Contracting States:
**DE FR GB IT**

(71) Applicant: **TEXAS INSTRUMENTS INCORPORATED**
**13500 North Central Expressway**
**Dallas Texas 75265(US)**

(72) Inventor: **Orcutt, John W.**
**3210 Collins BLvd**
**Garland Texas(US)**

(74) Representative: **Abbott, David John et al,**
**Abel & Imray Northumberland House 303-306 High**
**Holborn**
**London, WC1V 7LH(GB)**

(54) **Apparatus and method for semiconductor device packaging.**

(57) An apparatus and method for packing a semiconductor device having a strip (20) with a plurality of lead frames (40-49) with a semiconductor device (120) attached to the bar pad (56) of at least some of the lead frames. The strip (20) includes at least one solid thoroughfare (300) on its surface extending to at least two of the lead frames. Plastic in liquid form is supplied through a runner (265, 290) to a mold (190) containing the semiconductor devices (120) and the strip (20). The mold (190) forms a cavity (280) about the semiconductor device (120) and the portion of its associated lead frame adjacent to the semiconductor device (120). In particular the two semiconductor devices (120) attached to the lead frames adjacent the thoroughfare (300) are enclosed in two cavities (280). The plastic is directed over the thoroughfare (300) into the two cavities (280) adjacent to the thoroughfare (300).

EP 0 106 475 A1

./...

Croydon Printing Company Ltd

*Fig I*

-1-

## Method and Apparatus for Semiconductor Device Packaging

### Background of the Invention

Field of the invention.

The invention relates to the packaging of semiconductor devices and, more particularly, the invention relates to the packaging of semiconductor devices by plastic encapsulation.

Description of the Prior Art.

It is known to encapsulate semiconductor devices, for example, Integrated Circuits, with plastic as shown in U.S. Patent No. 4,043,027 issued to Birchler et al on August 23, 1977 and entitled "Process for Encapsulating Electronic Components in Plastic". The semiconductor devices are first attached to the bar pad of a lead frame. Contact pads on the semiconductor device are then individually attached by wire bonding, for example ball bonding, to corresponding contact pads on the ends of leads of the lead frame adjacent to but spaced from the bar pad. The attachment of the semiconductor device can be by any standard technique for example by alloying the surface of the semiconductor away from the surface having the active circuits located thereon to a surface of the bar pad.

The lead frame which can be attached to a plurality of other similar lead frames is then placed in a mold. The mold is provided with a cull or reservoir containing a quantity of raw plastic. A network of runners or channels extend from the cull to one or more cavities containing the semiconductor devices. The path of the plastic from the cull to cavity may extend through one or more cavities. In general, a gate or constriction is provided in the runner immediately prior to the cavity. The lead frame is seated in a chase or depression in the mold. The mold is generally constructed in two parts. The lead frame is seated into a chase in one part of the mold utilizing alignment stubs extending from the chase. The alignment stubs have corresponding alignment holes in lead frame to insure that the lead frame is properly seated into the chase. The other part of the mold is then brought into contact with the part having the lead frame seated therein. When properly aligned the semiconductor device is located in a cavity formed by depressions in both parts of the mold. The cavity is connected by a runner to the cull of the mold. Pressure is then applied to the plastic in the cull and forced under pressure through the runners into the cavity. The plastic encloses the semiconductor device, the bar pad of the lead frame, and the ends of the leads of the lead frame adjacent to the semiconductor device. The entire length of the wires individually connecting the contact pads of the semiconductor device and the contact pads on the ends of the leads of the lead frame adjacent to the semiconductor device are also enclosed. However, it should be noted that portions of the leads of the lead frame including the ends of the lead frame away from the semiconductor device are clamped between the two parts of the mold and are therefore outside the cavity. The portion of the lead frame outside the cavity is not enclosed by plastic. Heat is applied to the mold to cure the plastic to sufficient hardness. The mold is then opened and the lead frame removed. The operation is then repeated.

It has been found useful to form the lead frames in a strip. Each lead frame of a strip has a semiconductor device attached to its bar pad as discussed above. The bar pads are connected through supports to two parallel side rails. Each side rail is located in the plane of the lead frame and on opposite sides of the bar pad. The leads of each lead frame are formed into two sets extending generally parallel to the side rails from adjacent opposite sides of the bar pad. The leads of each lead frame are connected to the leads of at least one adjacent lead frame. Typically when the strip is placed into the chase of a mold, at least one other strip is placed into another similar chase of the mold. It is also known in the art to supply plastic to a cavity through another cavity. In the system, two lead frames are formed laterally adjacent between the side rails. The cavity of the lead frame adjacent the runner is connected to the cavity of the lead frame away from the runner.

The lead frames are constructed from a flat metal sheet by an etch technique or by a punch operation. After the encapsulated semiconductor device and lead frame are removed from the mold, they are generally placed in an oven for the application of heat to further cure the plastic. The individual leads are then separated. The leads are usually connected together to provide additional mechanical support during the assembly process and to provide a dam to prevent plastic from leaving the cavity between the leads. The support between the leads is outside the plastic encapsulating the semiconductor device and a portion of the lead frame. The separation of the leads is generally referred to as a trim operation. If the leads

-4-

are in a strip, the leads are then severed from the leads of the adjacent lead frames. The side rails are also separated from the leads and from the supports attached to the bar pad within the encapsulating plastic. An unique electrical connection has now been formed between the contact pads on the semiconductor device and the ends of the lead frame located outside the encapsulating plastic for the connection of the semiconductor device with other circuitry. For example, an electrical connection is formed from one contact pad on the semiconductor device through the wire attached thereto and the contact pad on the end of an adjacent lead to the end of the lead outside the encapsulating plastic.

None of the prior constructions shows encapsulating a semiconductor device utilizing a strip of lead frames wherein the plastic traverses a solid portion of the strip which acts to aid in the distribution of the plastic to at least two cavities having semiconductors devices and a portion of their associated lead frames located therein.

Summary of the invention

The apparatus of the present invention includes a flat sheet of metal, which can be, for example, of stainless steel. The metal sheet is either punched, etched, or by some other operation formed into a strip having a plurality of lead frames. Each lead frame has a bar pad and a plurality of leads. Openings separate the bar pad from the ends of the leads adjacent thereto. The bar pad is attached to two supports. The supports extend from opposite sides of the lead frame to the major portion of the strip. The leads extend from at least one side of the rectangular bar pad perpendicular to the sides from which the supports extend to another opposite end of the lead away from the end adjacent to the bar pad. The leads are connected together along a lateral line perpendicular to their longitudinal centerlines. This lateral connection forms a brace to provide additional mechanical support during the assembly operation acts as a dam during the encapsulating operation. The lateral connection is connected at each end to the major portion of the strip. The ends of the leads away from the bar pad can be connected to the major portion of the strip or to the leads of another adjacent lead frame. Since the strip and the lead frames it includes are formed from a flat metal sheet, the leads, the bar pad, and the major portion of the strip are substantially in the same plane. The major portion of the strip includes thoroughfares which extend adjacent each of the lead frames parallel to the leads and perpendicular to the supports connecting the bar pads to the major portion. The lead frames can be arranged in rows extending laterally across the strip. Two adjacent rows can have a thoroughfare extending from one longitudinal side of the strip adjacent to the other opposite longitudinal side. The rows of lead frames can be separated by a lateral opening along the side of the row away from its adjacent thoroughfare. The outer part of the major portion of the strip along its longitudinal sides forms two side rails. The side rails are provided with various indexing and alignment holes to provide a convenient area to motivate the strip and to insure proper alignment of the strip during the assembly process. The lateral openings extend laterally from one side rail at one end

-6-

to the other side rail at another opposite end thereof.

Semiconductor devices, which can be, for example integrated circuits, are attached to one surface of the bar pad. The semiconductor device can be attached by any standard technique, for example, by alloying. The surface of the semiconductor device away from the surface thereof attached to the bar pad has a plurality of contact pads thereon. The contact pads represent the input/output and power connections for the circuitry on the semiconductor device. At least some of the contact pads are connected to contact pads located on the ends of the leads adjacent the bar pads. In some cases not all of the contact pads are connected to the leads and not all of the leads are connected to a contact pad of the semiconductor device. The connections between the contact pads of the semiconductor device and the contact pads of the lead frame can be by wires. The wires can be attached by any standard technique for example ball bonding. The wires are very thin and relatively weak. Further, the bonds between the wires and the contact pads are mechanically weak. Therefore, it is desirable not to apply stress to this region. For this reason, semiconductor device manufacturers have found it necessary to enclose this region. One way of providing the necessary isolation is to encapsulate the region in plastic. The plastic encapsulation is accomplished by placing the lead frame in a mold.

The mold includes generally two parts. One part has a chase or shallow depression which aligns the strip. The face of the strip which includes the surface of the bar pads having the semiconductor can be located toward this part of the mold. The chase includes depressions. When the lead frames are properly aligned the central portion of the lead frame which includes the bar pad and a portion of the end of each lead adjacent the end thereof next to the bar pad are located over a depression. The depression is of sufficient depth that its bottom is well spaced from the wires and the surface of the semiconductor device opposite to the surface thereof attached to the bar pad. The lateral support extending between the leads is in contact with the surface of the part of the mold and is adjacent to but not within the depression. During an encapsulating operation, the other part of the mold is brought into close rigid contact with the part of the mold having the chase. The two parts of the mold have pressure applied thereto to maintain them in close contact. The second part of the mold has depressions which are similar to those in the first part. The depressions in the first and second parts of the mold cooperate to form cavities about the semiconductor device, the bar pad, wires, and the ends of the leads adjacent the bar pad. The major portion of the strip including the side rails is in contact with both parts of the mold. The portion of each lead outside the cavity is in contact with both parts of the mold. The lateral support between the leads is also in contact with both parts of the mold just outside the cavity. The second part of the mold also has at least one central runner or opening extending from a cull or reservoir of plastic and along the central portion of the thoroughfare. Side runners extend from each cavity to the central runner. The side runners are provided with a gate or constriction closely adjacent to the cavity.

During an encapsulating operation the plastic in the cull is subjected to pressure which causes it to become a liquid and flow down the central runner through the side runners over the surface of the thoroughfare into the cavities. Heat is then applied to partially cure' the plastic. The mold is then opened and the strip removed. The mold is ready for the next strip and the operation is repeated.

It is an advantage of the present invention to provide a strip of lead frames having increased density of lead frames.

It is another advantage of the present invention to provide increased production by increasing the number of semiconductor devices encapsulated in a single mold cycle.

It is also an advantage of the present invention to provide a strip of lead frames which has only one flash over point for several lead frames.

An additional advantage of the present invention is to provide an encapsulating process having reduced cost.

A further advantage of the present invention is to provide an an encapsulating process which does not leave plastic scrap in the mold.

It is a further advantage of the present invention to provide an encapsulating process wherein the plastic scrap is carried out of the mold attached to the strip of lead frames.

Brief Description of the Drawings

Figure 1 is a top view of a strip of lead frames constructed according to the present invention;

Figure 2 is a top view of the strip of lead frames of Figure 1 after encapsulation;

Figure 3 is top view of a plastic encapsulation apparatus utilizing the present invention;

Figure 4 is cross-sectional view taken along line 4-4 of Figure 3;

Figure 5 is a side view of a strip of lead frames within a mold;

Figure 6 is a top view of another strip of lead frames constructed according to the present invention;

Figure 7 is a side view of the runners in a mold used with the strip of leads shown in Figure 6; and

Figure 8 is a side view of a cavity formed about a portion of one of the lead frames of the strip shown in Figure 6.

Description of the Preferred Embodiment

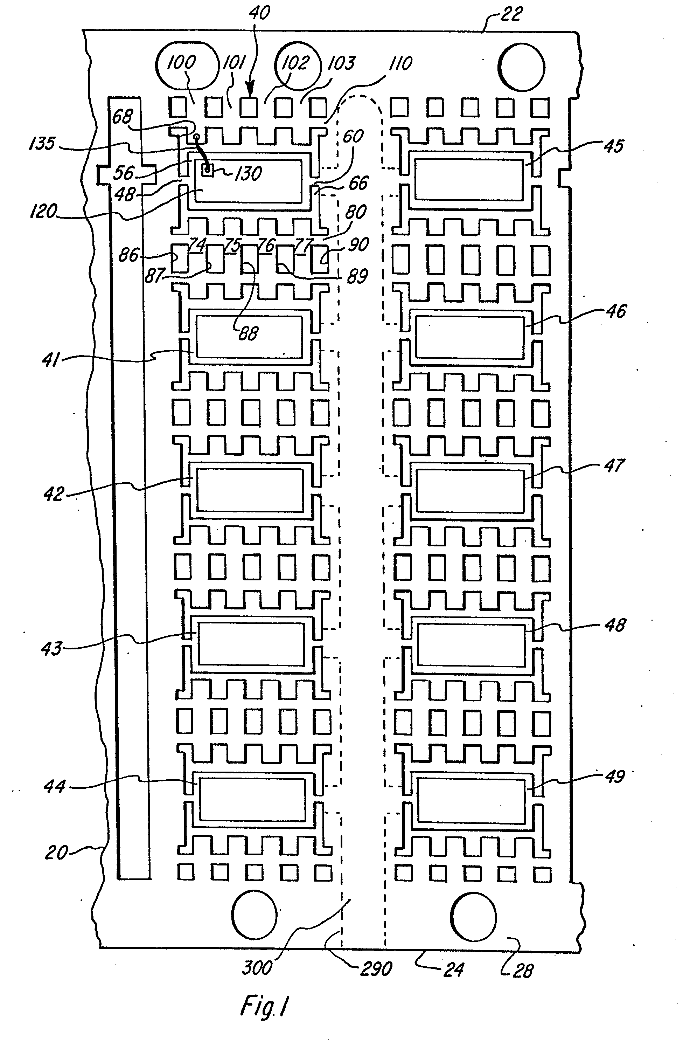

With reference to the drawings and in particular to Figure 1 thereof, a strip 20 is shown. Strip 20 is constructed from a flat sheet of metal for example stainless steel. The metal sheet has been etched or punched to produce the strip 20. Strip 20 has two longitudinal sides 22 and 24. The portions of strip 20 adjacent to longitudinal sides 22 and 24 form side rails 26 and 28, respectively. An opening 30 in strip 20 separates portions of the strip 20 which are connected only by side rails 26 and 28. Lead frames 40-49 are provided in strip 20. The other portions of strip 20 (not shown) can be provided with other lead frames. Although ten lead frames are shown in Figure 1 any convenient number can be provided. The lead frames 40-49 are similar and a detailed discussion of lead frame 40 shall suffice for all. Bar pad 56 has has a rectangular shape and is connected to lead frame 40 and therefore the major portion of strip 20 by supports 58 and 60. Lead frame 40 has openings 66 and 68. Opening 66 extends between bar pad 56, supports 58 and 60, and leads 74-77. Leads 74-77 extend from adjacent a side of bar pad 56 which is perpendicular to the sides having supports 58 and 60 attached thereto. The leads extend from their ends adjacent to bar pad 56 to other opposite ends away from bar pad 56. The leads 74-77 extend basically parallel. A lateral support 80 extends from the major portion of strip 20 across leads 74-77 to provide additional mechanical support during the assembly process and to act as a dam during encapsulation. Opening 66 is also bounded by lateral support 80. The smaller openings 86-90 extend between leads 74-77 and the lateral support 80. The end of leads 74-77 away from bar pad 56 are attached to the major portion of strip 20. Another set of leads 100-103 similar to leads 74-77 extends from ends adjacent a side of bar pad 56 away from the side of bar pad 56 to which an end of leads 74-77 is adjacent. A lateral support 110 is provided across leads 100-103 and is similar to lateral support 80. A semiconductor device 120 is attached to a flat surface of bar pad 56. The semiconductor device 120 has a plurality of contact pads (only contact pad 130 is shown) which are connected by wires (only wire 135 is shown) to the ends of the leads 74-77 and 100-103 (only the contact pad on the end of lead 100 is shown connected through wire 135 to contact pad 130 of semiconductor device 120). The connection of wire 135 can be by any standard technique, for example ball bonding. Although eight leads are shown in Figure 1, any number of leads can be utilized with the present invention.

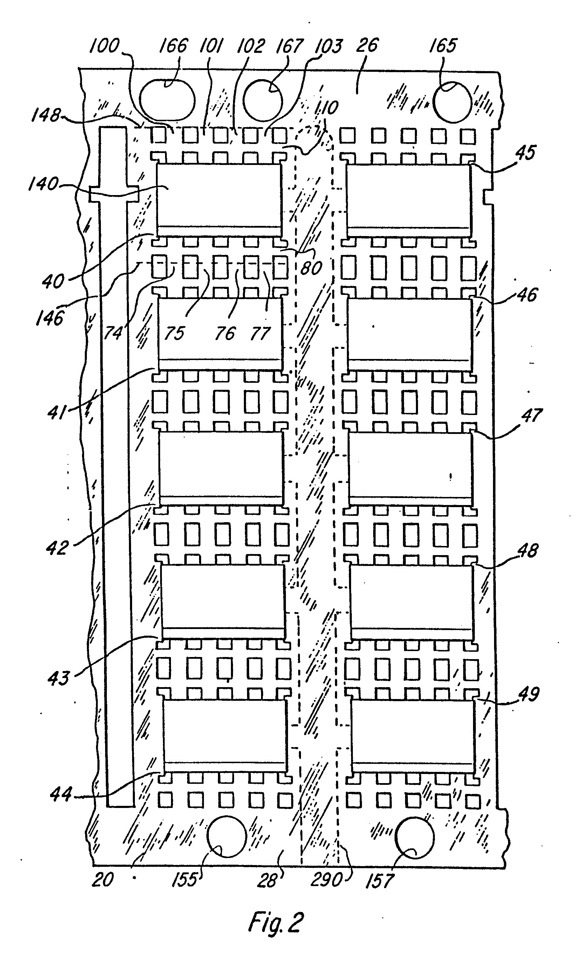

As shown in Figure 2, lead frame 40 is encapsulated with plastic forming an enclosure 140. Within the enclosure 140 is semiconductor device 120, bar pad 56, supports 58 and 60, and the ends of leads 74-77 and 100-103 adjacent to bar pad 56 (Figure 1). Enclosure 140 protects the wire bonding and semiconductor device from contact. When desired, leads 74-77 and 100-103 are severed along dotted lines 146 and 148, respectively, and the lateral supports 80 and 110 are severed between the leads to produce isolated electrical connections between the leads and the contact pads on the semiconductor device 120. Thus, electrical connection between the semiconductor device 120 and other circuitry is possible. The other lead frames 41-49 are encapsulated in a similar manner.

Holes 155 and 157 are shown in side rail 28. Holes 165-167 are shown in side rail 26. Holes 155 and 165, and 157 and 167 are located at similar locations. However an additional hole 166 is provided in side rail 26 to prevent upside down insertion of the strip 20. The holes 155, 157, and 165-167 provide alignment information and allow easy indexing of the strip 20.

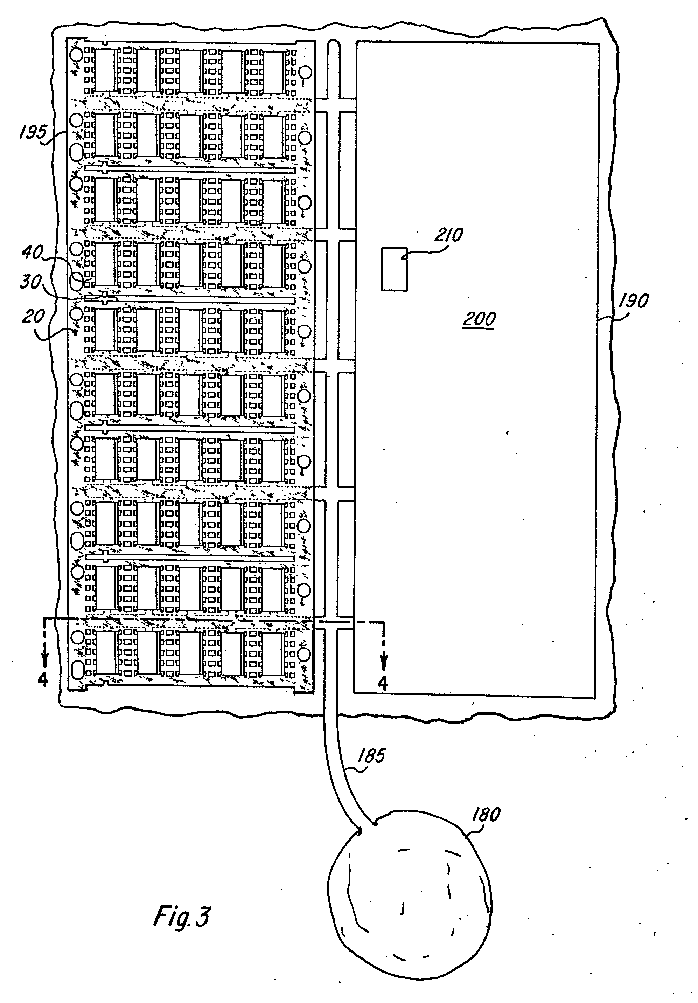

As shown in Figure 3, strip 20 has a number of openings similar to opening 30. The area between openings is similar to the area including lead frames 40-49 (Figure 1, only lead frame 40 shown in Figure 3). A cull 180 has a supply of plastic material therein. The cull 180 is connected through a runner 185 into a mold 190. The mold 190 has strip 20 therein. The strip 20 is located in a chase 195, which is similar to chase 200.

Chase 200 is adapted to receive a strip (not shown) which is similar to strip 20. A plurality of depressions in chase 200 (only depression 210 is shown) are located for the semiconductor devices, the bonding wires, and the portion of the leads adjacent the bar pad to be disposed therein. The depression is sufficiently deep to prevent contact with the wires or the semiconductor device. In fact the depth of the depression is approximately half of the desired height of the enclosure. The chase 200 is itself a shallow depression adapted to receive a strip of lead frames similar to strip 20 in close fit. The other part of mold 190 is provided with depressions corresponding to for example depression 210 in chase 200. The combination of the two depressions when the mold 190 is closed is create a cavity having the shape and volume of enclosure 140 (Figure 2). When pressure is applied to the plastic in cull 180, it flows down runner 185 and into subrunners until it reaches the cavities where the semiconductor devices are located. U.S. Patent No. 4,043,027 issued to Birchler et al on August 23, 1977 and entitled "Process for Encapsulating Electronic Components in Plastic", which is incorporated by reference hereinto, discusses general molding techniques.

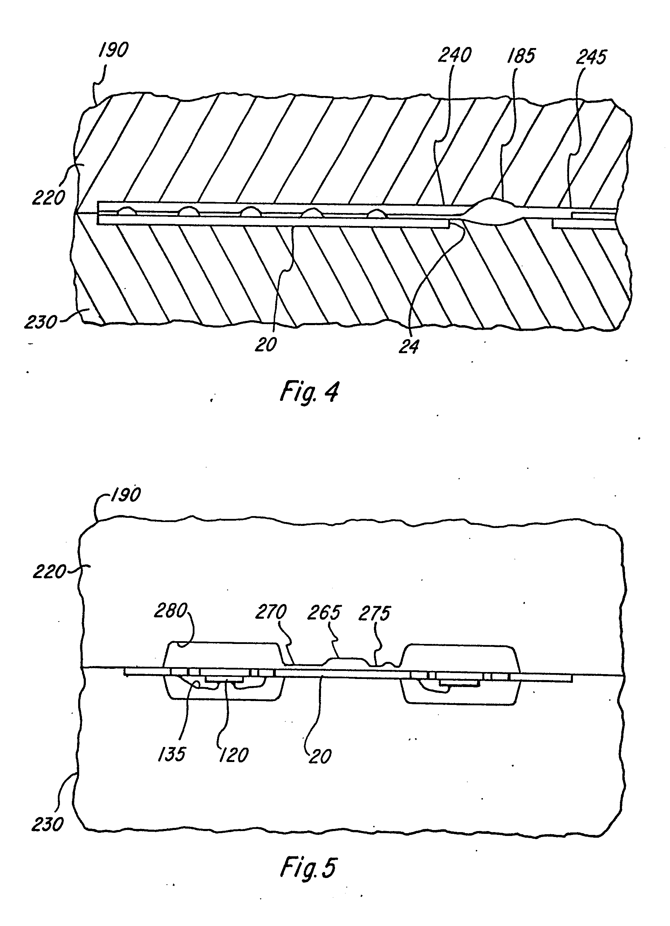

As shown in Figure 4, the mold 190 has an upper part 220 and a lower part 230. The subrunners 240 and 245 branch off perpendicularly from runner 185. Subrunners 240 and 245 each feed five runners which connect the subrunners to the cavities where the semiconductor devices are located. It should be noted that the upper part 220 and the lower part 230 of mold 190 are held in closed contact by pressure. It should be noted that the

subrunner 245 only passes over the side 24 of strip 20 once. Thus only one discontinuity is presented to the flow of plastic along subrunner 245 and that is at the passage over side 24. This eliminates a major cause of contamination of the mold 190 from plastic not being firmly connected to the strip and breaking off in the mold.

As shown in Figure 5, a subrunner 265 branches off into runners 270 and 275. Runner 270 leads into the cavity 280 formed between parts 220 and 230 of mold 190. The plastic flows through runner 270 and into cavity 280. The lower portion of the cavity is filled by the plastic flowing through the openings 66, and 68 (Figure 1). The location of subrunner 265 is shown in Figure 1 by dotted line 290. The thoroughfare 300 between the rows of lead frames with one row formed by lead frames 40-44 and another row formed by lead frames 45-49 allows the plastic to pass over one surface of the strip until it reaches a cavity. A gate 310 is provided to allow easy separation of the enclosure 140 (Figure 2) and from the plastic filling runner 270 after the mold is opened and the plastic cured.

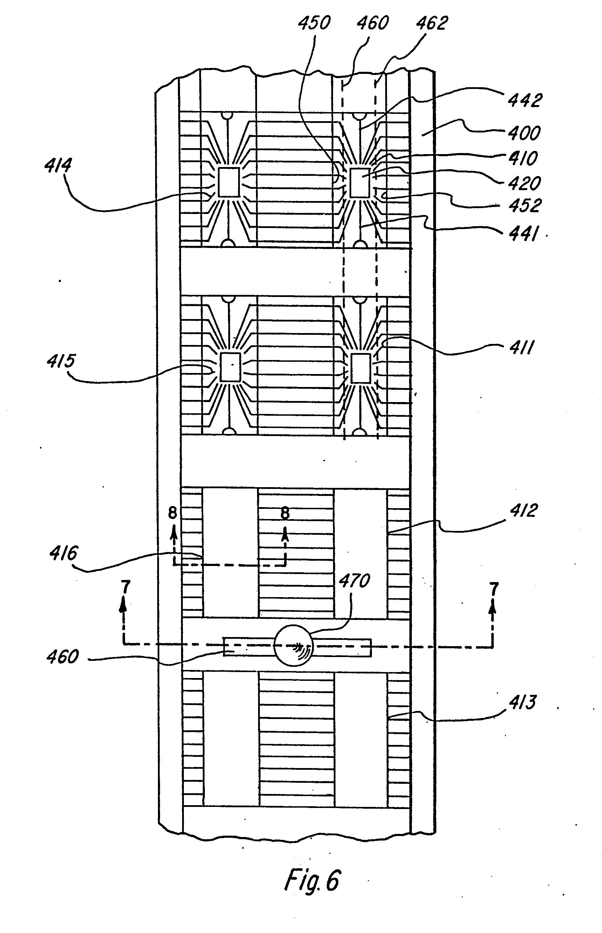

A strip 400 is shown in Figure 6. Strip 400 has a plurality of lead frames 410-417. Each of the lead frames is similar and a detail discussion of lead frame 410 shall suffice for all. It should be noted that lead frames 412, 413, 416, and 417 are encapsulated in plastic. Lead frame 410 has a bar pad 420 a plurality of leads 430. The leads extend from an end adjacent to bar pad 420 to another opposite end. Supports 440 and 442 extend perpendicularly from sides of bar pad 420. The supports 440 and

-14-

442 maintain bar pad 420 in stable relationship with the remainder of lead frame 410. The supports extend across openings 450 and 452. The leads 430 also extend across openings 450 and 452. The leads are divided into two set which extend from opposite sides of the bar pad. The remainder of the strip is solid except for any indexing or alignment holes if any. If it is desired to coat the lead ends adjacent to the bar pad with for example silver or aluminum it possible to do so by moving the strip 400 in its longitudinal direction (vertically as shown in Figure 6). The coating can then be applied between the dotted lines 460 and 462 onto lead frames 410, 411 etc. The same operation can be performed for lead frames on the side of strip 400 including lead frames 414 and 415.

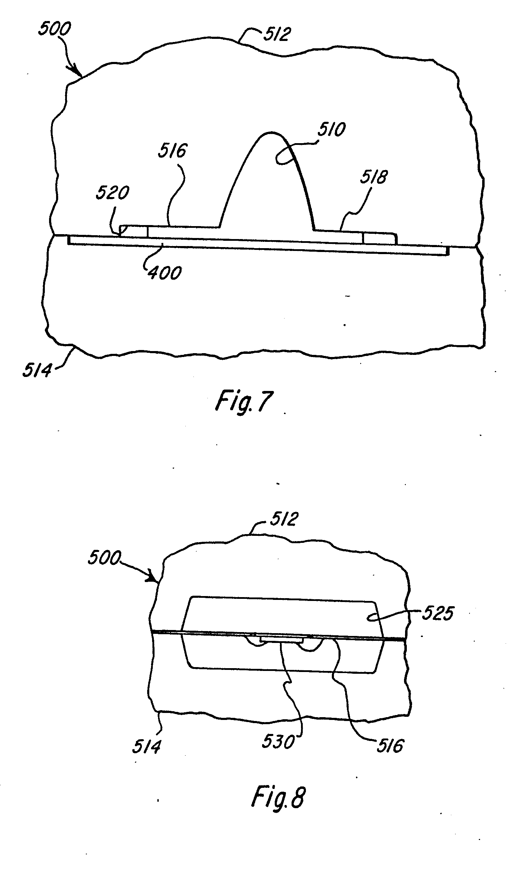

During an encapsulating operation, a plastic pellet is placed at a central location 470 between four lead frames 412, 413, 416, and 417 on the upper surface of strip 400. The portion of strip 400 including lead frames 412, 413, 416, and 417 and the pellet are placed in a mold 500. The mold 500 as shown in Figures 7 and 8 has a depression 510 in its upper part 512. The depression 510 is adapted to receive the pellet of plastic. When the two parts 512 and 514 of the mold 500 are brought together under pressure the plastic flows out of depression 510 and along runners 516 and 518. From runner 516 the plastic flows through runner 520 to a cavity 525 formed by depressions in parts 512 and 514 of mold 500 containing a a portion of lead frame 416 and semiconductor device 530 with the required connecting wires. The other lead frames 412, 413, and 417 have similar cavities and are supplied with plastic through runners in a similar manner.

-15-

It should be noted that utilizing the strip 400 and the mold 500 the upper surface of the strip forms one surface of the mold to force the flow of plastic. Further, it should be noted that the plastic does not flow over any discontinuities, for example, the side of a strip. A discontinuity is called a flash over point. It should also be noted that this method of encapsulation insures that the scrap (shown generally at 560) is carried out of the mold by the strip. This insures that the mold is clean for the next strip to be molded. Heat is applied to the mold as discussed above to cure the plastic prior to opening the mold. Curing of the plastic is completed in an oven after removal of the strip from the mold.

Having described the invention in connection with certain specific embodiments thereof, it is to be understood that further modifications may now suggest themselves to those skilled in the art. It is intended to cover all such modifications such as fall within the scope of the appended claims.

-16-

WHAT IS CLAIMED IS:

1.       An apparatus for packaging semiconductor devices within encapsulating plastic enclosures comprising:

(a)  a substantially flat metal strip having two longitudinal sides, a plurality of lead frames therein, and at least one solid thoroughfare on a flat surface extending from one longitudinal side to at least a first and second lead frames, each lead frame provided with a bar pad having a semiconductor device attached thereto and a plurality of leads, each lead extending from one end adjacent said bar pad to another opposite end away from said bar pad;

(b)  a cull of encapsulating plastic selectively under pressure; and

(c)  a mold having a first and second parts movable between a closed and open positions, said first part adapted to receive at least a portion of said strip therein when in said open position in a predetermined alignment, said strip maintained in said predetermined alignment when said mold is in said closed position, said first and second parts including a plurality of depressions forming two cavities with one cavity about a portion of each lead of said first lead frame adjacent said one end and a first semiconductor device attached thereto and with another cavity about a portion of each lead of said second lead frame adjacent said one end and a second semiconductor device attached thereto, and a runner connecting said cull over said one longitudinal side along said thoroughfare with said one and another cavities when said mold is in said closed position and said strip is in said predetermined alignment.

2.    An apparatus for encapsulating semiconductor devices within plastic comprising:

(a)    a substantially flat metal strip having two longitudinal sides and a plurality of lead frames arranged therein with a thoroughfare extending over a solid surface of said strip to a first and second lead frames, said first lead frame having a first semiconductor device attached thereto and said second lead frame having a second semiconductor device attached thereto;

(b)    a first means for selectively supplying plastic in fluid form under pressure;

(c)    a second means having said strip aligned therein with said first semiconductor device and a portion of said first lead frame adjacent thereto in a first cavity and with said second semiconductor device and a portion of said second lead frame adjacent thereto in a second cavity; and

(d)    a third means connected to said first means and said second means for directing plastic over said thoroughfare into said first and second cavities.

3.      A method of encapsulating a first and second semiconductor devices within plastic comprising the steps of:

(a)   aligning said strip within a closed mold with said first semiconductor device and a portion of said first lead frame adjacent thereto in a first cavity and with said second semiconductor device and a portion of said second lead frame adjacent thereto in a second cavity; and

(b)   directing plastic under pressure over a solid thoroughfare of said strip into said cavity and into said second cavity.

Fig.1

0106475

2 / 6

*Fig. 2*

Fig.3

Fig. 4

Fig.5

Fig. 6

Fig. 7

Fig. 8

European Patent
Office

**EUROPEAN SEARCH REPORT**

Application number

EP   83 30 5062

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| Y | US-A-3 753 634   (BLIVEN et al.) <br> * Column 3, lines 25-37 * | 1-3 | H 01 L   21/56 <br> B 29 C    6/04 |
| | --- | | |
| Y | EP-A-0 007 762   (D. SLEPCEVIC) <br> *  Page 8, line 19 - page 9, line 30 * | 1-3 | |
| | --- | | |
| A | GB-A-2 073 947   (PHILIPS) <br> * Page 3, lines 49-78 * | 1-3 | |
| | ----- | | |

**TECHNICAL FIELDS SEARCHED (Int. Cl. ³)**

B 29 C    6/00
B 29 F    1/10
H 01 L   21/56
H 01 L   23/48

The present search report has been drawn up for all claims

| Place of search <br> BERLIN | Date of completion of the search <br> 02-11-1983 | Examiner <br> GIBBS C.S. |
|---|---|---|

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO Form 1503. 03.82